Europäisches Patentamt

European Patent Office

Office européen des brevets

(19)

(11) Publication number: **0 037 192**

A1

## (12) EUROPEAN PATENT APPLICATION

(21) Application number: **81301011.3**

(22) Date of filing: **11.03.81**

(51) Int. Cl.³: **G 08 C 9/08**
**G 01 D 5/245, H 03 K 13/18**

(30) Priority: **14.03.80 US 130310**

(43) Date of publication of application:
**07.10.81 Bulletin 81/40**

(84) Designated Contracting States:
**DE FR GB IT**

(71) Applicant: SPERRY CORPORATION
1290, Avenue of the Americas
New York, N.Y. 10019(US)

(72) Inventor: Kelley, Michael Ray
8025 North 5th Avenue
Phoenix Arizona 85021(US)

(72) Inventor: Dassele, Michael Albert
13421 N. 50th Street
Scottsdale Arizona 85254(US)

(72) Inventor: Emfinger, Jack Ellis
1947 W. Village Drive
Phoenix Arizona 85023(US)

(74) Representative: Singleton, Jeffrey
Sperry Gyroscope Patent Department Downshire Way
Bracknell, Berkshire, RG12 1QL(GB)

(54) Angle repeater means for converting shaft rotation into representative pulsed signals.

(57) The invention includes an optical pulse-forming switch (30) interfaced with a pair of synchronised flip-flops and a phase detection and counter control circuit (39) which senses rotation extent and direction. The counter control circuit (39) drives a counter (10) that stores the number of passed angular increments and stores direction of rotation, the counter (10) being interrogated and reset at regular time intervals. Thus, the input shaft rotation is converted into a digital quantity by maintaining a running summation of counter values. The operator reference indicator (1) is accordingly brought up to date following each input conversion.

EP 0 037 192 A1

./...

FIG.I

- LATCHES
- BCD-TO-DECIMAL DECODERS.
- DRIVERS.

DIGITAL COMPUTER
- CONTINUOUS SUM OF INCREMENTAL DETENT COUNTER
- BINARY-TO-BCD CONVERSION OF SUM COUNT.

CLK

COUNT OVERFLOW PROTECT

INCREMENTAL DETENT COUNTER

PULSE SYNCHR.

PHASE DET. AND COUNTER CONTROL

DN

UP

UNITS —— ×1000

Angle Repeater Means for Converting Shaft
Rotation into Representative Pulsed Signals.

This invention relates to shaft angle repeater means for converting a shaft rotation into pulsed signals, for example for computer processing and for display on an operator's reference indicator.

In the prior art, conversion of shaft angle into a digital representation has been accomplished by using a shaft-driven synchro and asscciated electronic analog-to-digital conversion apparatus, by a coded wafer contacting switch, or by a binary coded optical shaft encoder. The first approach demands the use of a synchro data transmitter that must be precise and electrically balanced and which is therefore expensive. In addition, analog-to-digital converters are known to be sensitive to temperature and to other ambient effects unless suitable compensation is made. While they are fundamentally simple, coded wafer contacting switches exhibit electrical arcing and contact bounce at least after a period cf use and thereby cause undesirable errors in associated electronic equipment. Commercially available optical shaft encoders are too large for incorporation in locations such as aircraft control panels and are, in addition, quite expensive.

It is an object of the present invention to provide shaft angle repeater means which substantially overcomes the problems associated with the prior art. According to the invention there is provided shaft angle repeater means including rotatable shaft means, means permitting the rotatable shaft means normally to assume any one of a plurality of equiangularly spaced locations, angle pick-off means cooperating with the rotatable shaft means for producing first and second pulse trains, each pulse thereof being substantially symmetric, when the rotatable shaft means is rotated from a first to a second of said equiangularly spaced locations, the first and second pulse trains having the respective pulses thereof aligned in cooperating-overlapping relation whereby the pulses of the first pulse train are formed first for one sense of rotation of the rotatable shaft means and the pulses of the second pulse train are formed first for the second sense of rotation of the rotatable shaft means, first circuit means responsive to the first formed pulses for generating a signal representative of the sense of rotation of the rotatable shaft means, second circuit means responsive to the first and second pulse trains for generating a signal representative of the number of the pulses, and utilisation means responsive to the signal representative of the sense of rotation of the rotatable shaft means and to the signal representative of the number of the pulses.

The preferred repeater means includes an optical pulse-forming switch interfaced with a pair of synchronised flip-flops and a phase detection and counter control circuit which senses rotation extent and direction. The counter control circuit drives a counter that stores the number of passed angular increments and stores direction of rotation, the counter being interrogated and reset at regular time intervals. Thus, the input shaft rotation is converted into a digital quantity by maintaining a running summation of counter values. The operator reference indicator is accordingly brought up to date following each input conversion.

Shaft angle repeater means forming a preferred embodiment of the invention will now be described by way of example, with reference to the accompanying drawings, in which:-

Figure 1 is a schematic representation of the repeater means, showing in perspective view the mechanical parts of the repeater means together with electrical components and their interconnections,

Figure 2 is a partial cross-sectional view of a detent element of Figure 1,

Figure 3 is a cross-sectional view of a pick-off of Figure 1,

Figure 4 is an elevation of a shutter shown in Figure 3,

Figure 5 is an electrical wiring diagram of a circuit employed within the pick-off of Figure 3,

Figure 6 is a graph useful in explaining the operation of the repeater means,

Figures 7A and 7B are together a detailed wiring diagram of the electrical or signal processor portion of the repeater means of Figure 1.

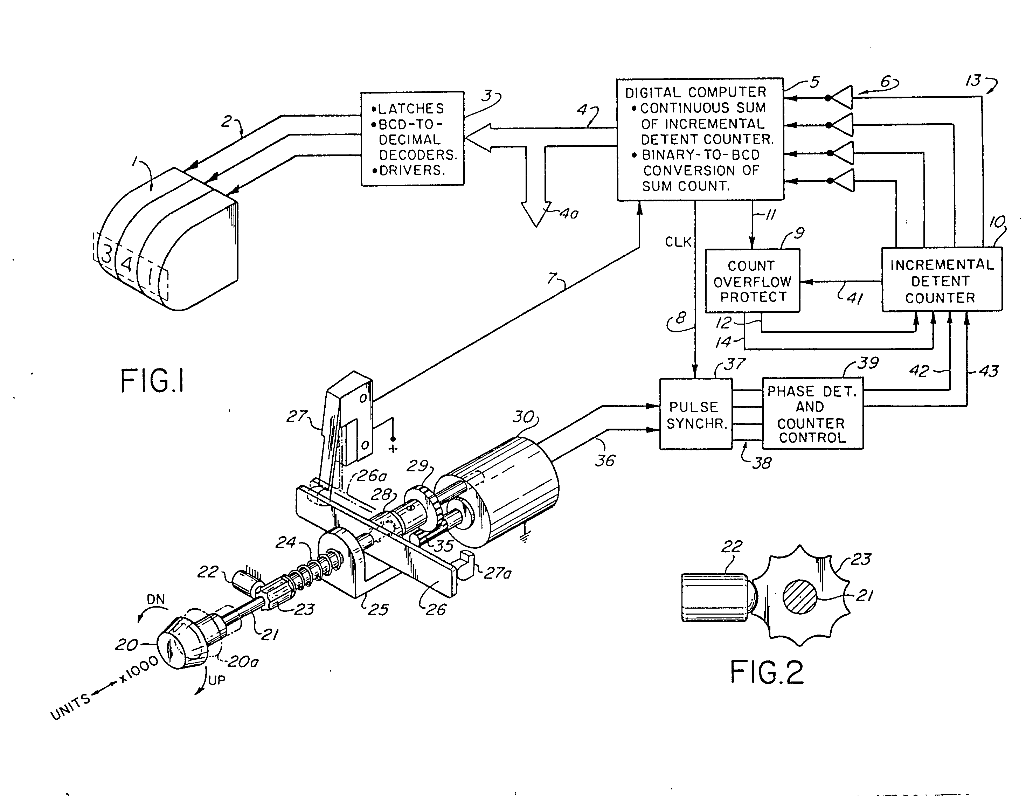

In Figure 1, there is illustrated repeater means whereby an operator may use a mechanically rotatable knob 20 to set a selected command value into a computer 5 and simultaneously to display that selected value in a conventional numerical display 1. The repeater means may also be employed, for example, to set into a cooperating universal or specialised computer any kind of data for employment therein for the control of a navigation system. For example, the novel selector-display may be used to handle any one of a variety of automatic pilot command parameters, such as altitude, vertical air speed, craft heading, air speed, or the like. Any one of a wide variety of types of display device may be used as the display 1, including numerical displays such as the common mechanical wheel counter display.

The opto-mechanical portion of the repeater means may be understood from Figures 1 to 6 in general relation to the cooperating electrical parts. Referring particularly to Figure 1, the knob 20 is mounted on a shaft 21 which is rotatable with respect to a bearing within a support bracket 25 affixed to an instrument panel of the aircraft, the panel also supporting an optical pick-off 30. The rotational positions of the knob 20 and of the shaft 21 are restrained to ten possible positions by the conventional detent 22 and detent wheel 23, shown also in the enlarged view of Figure 2, the detent wheel 23 being fixed on the shaft 21. Any rotation of the shaft 21 is conveyed through a gear 29 to the smaller input gear 35 of the pick-off 30. In one embodiment of the invention, a five to one gear ratio is used, so that the gear 35 rotates five times for each rotation of the gear 29.

One advantageous feature of the repeater means is that the scale factor of the display 1 may be changed at the will of the operator. For example in an altitude select system, the presentation of display 1 may be shifted from hundreds to thousands of feet altitude, and the computer 5 and associated apparatus may be at the same time alterted of that change for compensation thereof.

For the scale controlling purpose, the knob 20 and the shaft 21 may be translated along the axis of the shaft 21 to the position represented at 20a in broken lines, whereby a switch armature 26 is also translated to position 26a. The armature 26 is supported on the shaft 21 by a bearing 28 and is constrained from rotation by its proximity to the upper surface of the bracket 25, for example. Miniature switches, such as switches 27 and 27a, are actuated by the translational motion of the armature 26 and are returned to their original positions when a spring 24 returns the shaft 21 and the knob 20 to their normal or initial positions. It will be clear to those skilled in the art that the computer 5 may be equipped with a program or a conventional discrete computing unit for accomplishing such scale changes, so that the count supplied to the display 1 actuates the device as a 1000 foot display rather than as a 100 foot display, or vice versa, at the will of the operator.

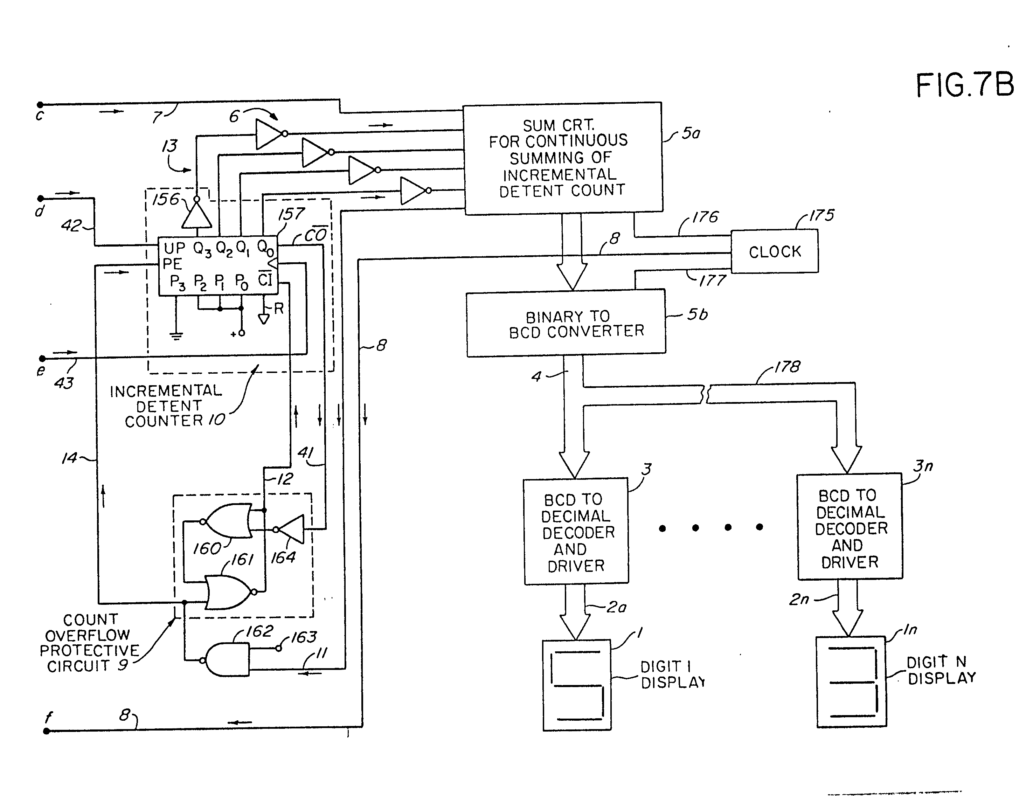

Still referring to Figure 1, the encoded output of the pick-off 30 is coupled via leads 36, together with clock signals on a lead 8, to a pulse synchroniser 37. The output of the synchroniser 37 flows via a plurality of leads 38 into a phase detector and counter control circuit 39. The circuit 39 performs the function of identifying the direction of rotation of the knob 20 and of detecting each detent passage. The output of the circuit 39 on leads 42,43 drives an incremental detent counter 10, which may take the form of a conventional up-down counter that stores the number of detents passed and also information representing the direction of rotation of the knob 20. The counter 10 is interrogated and reset at regular intervals by the conventional general or specific purpose computer 5, which converts the data stored in the up-down counter 10 and supplied by leads 13 to the computer through a corresponding plurality of inverting amplifiers 6, thus maintaining a running summation of counter values therein. It will be understood that the computer 5 contains at least two conventional elements, a sub-system 5a (Figure 7B) for the continuous summation of the incremental detent counter outputs and, responsive to the sub-system 5a, a sub-system 5b (Figure 7B) for converting the foregoing summation by binary-to-BCD conversion into signals of a character useful in a conventional display system 1, 2, 3 or, via the leads 4a, in a flight control system or navigation computer.

The display system is responsive to signals on the leads 4 and includes a conventional serially active combination 3 of input signal latches, BCD-to-decimal decoders, and drivers. The latter elements supply control signals via leads 2 to operate the individual dials of the display 1 for presenting the commanded series of digits. The operator's reference display 1 is thus up-dated with a converted input following each input conversion. The counter 10 interrogation interval is so fixed that it is extremely improbable that the incremental detent count of the up-down counter 10 will exceed the capacity of that counter. However, this undesired event may sometimes occur, so that an overflow protection circuit 9 is provided. The synchronisation of the pulse synchroniser 37 is achieved by clock pulses on the lead 8 which may arise in the clock controlling computer 5, and is gated off during computer interrogation, thereby guaranteeing stable data during count transfer into the computer 5.

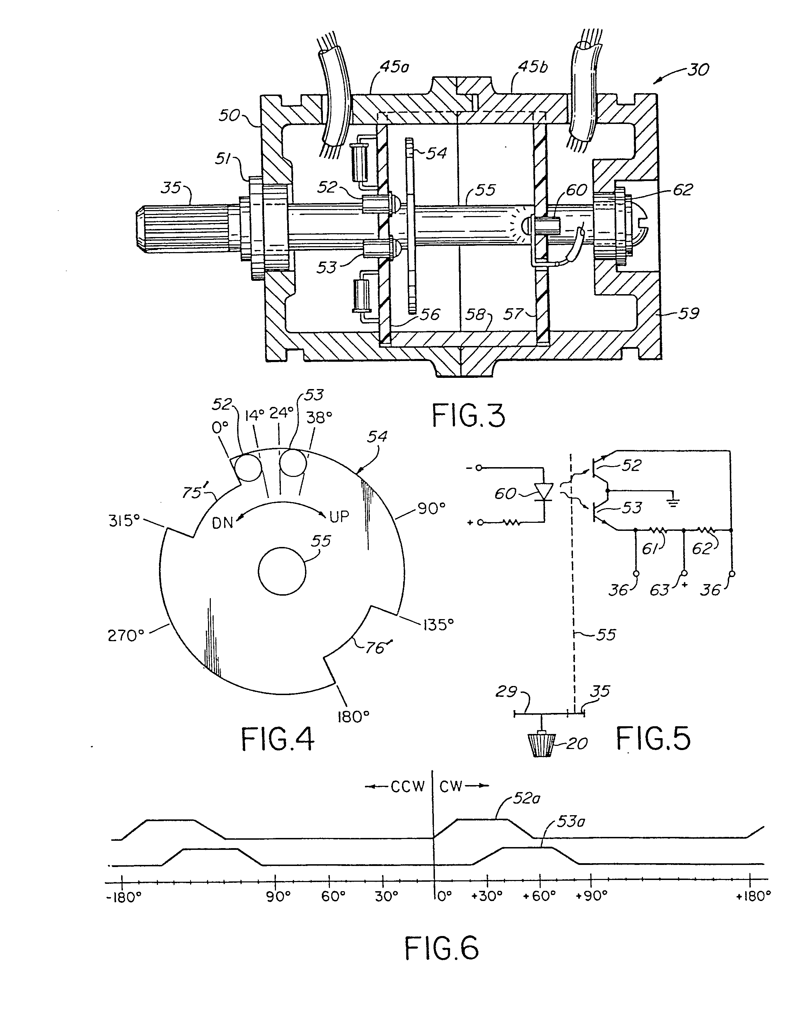

The internal nature of the pick-off 30 may be understood from Figures 3 to 6. The gear 35 of Figure 1 is integral with a shaft 55 journalled in the respective bearings 51, 62 in the end portions 50, 59 of a split cylindrical casing 45a, 45b of the pick-off 30. Two plastics circuit boards 56, 57 are mounted within the casings 45a, 45b, being securely held in place by inserts such as insert 58. The two casings 45a, 45b may be secured together by conventional fasteners (not shown).

A light emitting electroluminescent diode 60, or other suitable light source, is supported by the circuit board 57 and may be energised as indicated in Figure 5 by a suitable electrical source. A matched pair of diode or other light detectors 52, 53 is similarly disposed on the second circuit board 56 above the shaft 55 so that they may receive light from the source 60. As shown in Figure 5, the detectors 52, 53 are coupled in series with two resistors 61, 62; the common junction of the detectors 52, 53 is coupled to ground, while a suitable operating voltage is coupled to a terminal 63 common to the resistors 61, 62. The useful output to be supplied via the leads 36 to pulse synchroniser 37 is derived across the resistors 61, 62. A redundant set of two detectors and a light source may be disposed on the opposite side of the shaft 55.

Interposed between the light source 60 and the pair of detectors 52, 53 is a rotatable shutter 54 seen best in Figure 4. The shutter 54 is fixed to the shaft 55 for rotation therewith and is provided with equiangular diametrically opposed cut-out portions 75', 76' disposed so that the shutter 54 displays diametral symmetry. As the shutter 54 is rotated clockwise with respect to its zero position, the detector 52 is the first to see light from the source 60, while the detector 53 sees it momentarily later, as at 52a and 53a in Figure 6. However, should the shutter 54 be rotated counter-clockwise with respect to its zero position, the detector 53 is first illuminated, while the detector 52 receives light momentarily later. In other words, the order in which the detector output signals 52a, 53a appears on the leads 36 conveys information as to whether the commanded value is greater or less than the immediately prior value. Further, the number of pulses in the signal 52a or 53a conveys information as to the magnitude of the commanded change.

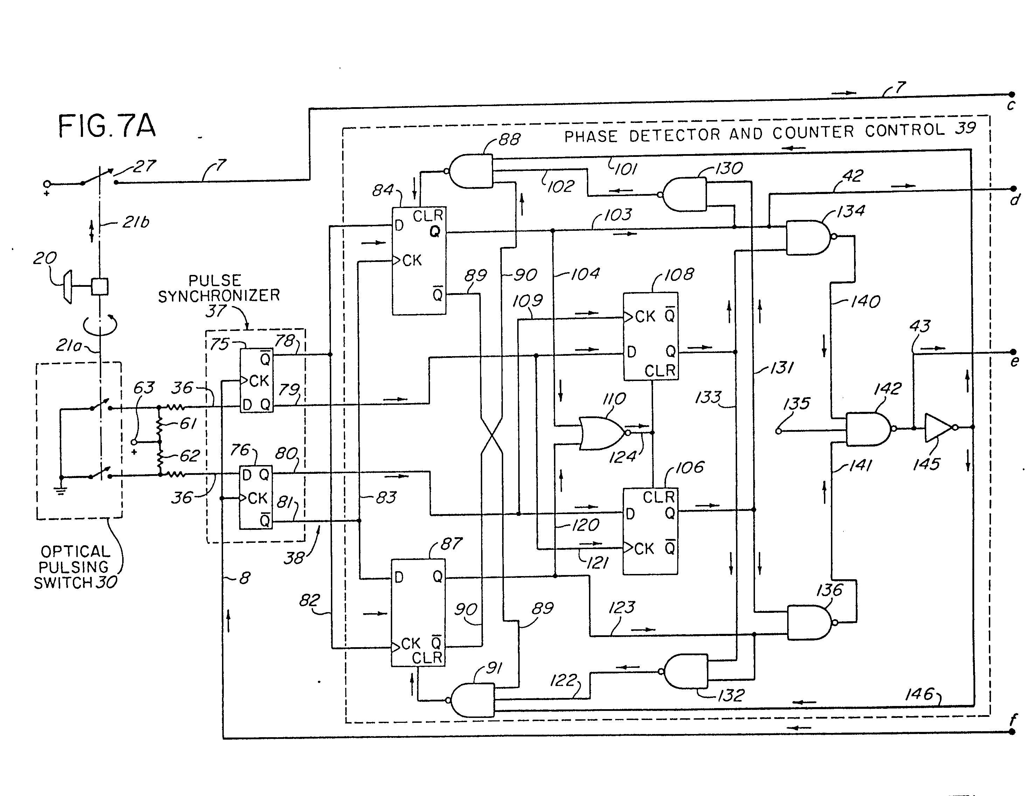

Referring now to Figure 7A, the optical pick-off 30 (or optical pulse generating switch) is shown only schematically as supplying across the resistors 61, 62 the signals of Figure 6 to the pulse synchroniser 37. The leads 36 are coupled to the data inputs D of synchronised flip-flops 75, 76 included within the pulse synchroniser 37. The flip-flops 75, 76 additionally have synchronising clock inputs CK supplied via the lead 8 from clock 175, which clock may also control computer sub-systems 5a, 5b. The flip-flops 75, 76 each supply Q and $\overline{Q}$ outputs via their respective output leads 78, 79, 80, 81.

The outputs of the flip-flops 75, 76 are supplied to inputs of the phase detector and counter control circuit 39. For example, the $\overline{Q}$ output of the flip-flop 75 on the lead 78 goes via lead 82 to the data input D of flip-flop 84 of the phase detector section and also to the clock input CK of a similar flip-flop 87. Conversely, the $\overline{Q}$ output of flip-flop 76 on lead 81 goes via lead 83 to the clock input CK of flip-flop 84 in the phase detection section and to the data input D of flip-flop 87. The flip-flops 84, 87 are respectively supplied with clearing terminals CLR operated by signals from the respective NAND gates 88, 91, each supplied with a trio of input signals from sources yet to be discussed.

The Q output of the flip-flop 75 of the pulse synchroniser 37 is coupled via lead 79 to the data input D of flip-flop 108 and via lead 121 to the clock terminal of flip-flop 106. Conversely, the Q output of flip-flop 76 is connected via lead 80 to the data input D of flip-flop 106 and via lead 109 to the clock input CK of flip-flop 108. The respective Q outputs of the flip-flops 84, 87 are coupled by leads 104, 120 to the inputs of NOR gate 110, whose output is conveyed by lead 124 to the clearing terminals CLR of flip-flops 108, 106.

The Q output of the flip-flop 108 flows via lead 133 to inputs of NAND gates 134, 132, while the Q output of flip-flop 106 flows via lead 131 to the inputs of NAND gates 130, 136. The respective second inputs for NAND gates 134, 136 come from the respective Q outputs of flip-flops 84, 87 via the respective leads 103, 123. The outputs of NAND gates 134, 136 flow through the respective leads 140, 141 to two of the inputs of NAND gate 142, which gate has a third input 135 for a signal representative of the fact that operating power has been supplied to the system. The output of NAND gate 142 is supplied from the counter control section via lead 43 to the incremental detent up-down counter 10 of Figure 7B. When power is first switched on, a short-duration pulse is immediately supplied from a conventional power supply source which sets all memory circuits (the flip-flop and counter) in a conventional manner to a pre-determined condition; i.e., the flip-flops are cleared, while the counter is preset to mid-range value 0 1 1 1.

For controlling the sequence of operation of the circuit of Figure 7A, the flip-flop 84 Q output on lead 103 is coupled to one input of NAND gate 130, the other input thereto receiving the Q output of flip-flop 106 via lead 131. The output of NAND gate 130 is sent via lead 102 to one of three inputs of NAND gate 88. A second input to NAND gate 88 is the $\overline{Q}$ output of flip-flop 87 on lead 90. A third input is generated by the output of NAND gate 142 and the inverting amplifier 145 and is supplied through lead 101 to NAND gate 88, all for the control of the clearing terminal CLR of flip-flop 84.

A generally analogous circuit involves NAND gates 132 and 91. The flip-flop 87 Q output on lead 123 is coupled to one input of NAND gate 132, the other input thereto receiving the Q output of flip-flop 108 via lead 133. The output of NAND gate 132 is sent via lead 122 to one of three inputs of NAND gate 91. A second input of NAND gate 91 is the $\overline{Q}$ output of flip-flop 84 on lead 89. A third input is again generated by the output of NAND gate 142 and the inverting amplifier 145 and is supplied through lead 146 to NAND gate 91, all for the control of the clearing terminal CLR of flip-flop 87.

In Figure 7a, axial translation of the shaft 21 is indicated at 21b and rotation of the shaft 21 at 21a. The switch 27 is connected by lead 7 to sub-system 5a.

In operation, assume that the rotation of the manual input knob 20 is to be such as to produce an up count in the counter 10. The signal 52a of Figure 6 is first to rise as the knob 20 is rotated out of its initial detent. The fact of the occurrence of this input signal rise is indicated by the stored level of the Q output of the flip-flop 84 upon the first subsequent rising of the signal 53a, which will be last up in this case. If rotation of the knob 20 is continued over the detent ridge to the next detent valley position, the signal 52a is the first to drop. This sets the Q output of flip-flop 108 when the falling edge of the signal 53a occurs. The state of the Q output of the flip-flop 84 indicates on lead 42 than an up count is to be taken by the counter 10 and the logical combination of the outputs of the Q outputs of the flip-flops 84 and 108 produces a counter clock on the lead 43. This clock signal, when coupled to the clock input of the counter 10, increments the counter 10 by one unit. The same clock signal resets the Q output of the flip-flop 84, which event also resets the output of the Q terminal of the flip-flop 108. The cycle is completed, all elements being put back in condition for the initiation and completion of a second cycle when commanded. It will be observed that the circuit 39 is symmetrical, having similar upper and lower parts, and because of this symmetry its second half operates in an analogous manner when the knob 20 is rotated to produce a down count in the counter 10, flip-flops 87 and 106 being involved, for example, in place of flip-flops 84 and 108.

A feature of the phase detector and counter control logic circuit 39 lies in the fact that it substantially eliminates the possibility of multiple counts by the counter 10 which might otherwise be caused by rotational noise due to mechanical jitter induced, for example, by any uncoordinated manual operation of the knob 20. For example, false counts might otherwise be produced by partial rotation of the knob 20 just short of the point at which the detent 22 would slip over a ridge of the detent wheel 23, so that the knob 20 then returns to the last secured detent valley position. The problem is discriminated against by gates 134 and 136 by ensuring that the first of the signals 52a, 53a to be up is also the first signal to drop to the zero level. In the foregoing example, elimination of these undesirable effects is also promoted by holding the Q outputs of the flip-flops 106, 108 reset until either the Q output of the flip-flop 84 or of the flip-flop 87 is set and also by holding the Q output of the flip-flop 87 reset by the Q output of the flip-flop 84 and the Q output of the flip-flop 84 reset by the Q output of the flip-flop 87. The triple-input NAND gates 88, 91 clear the first up flip-flops if a counter clock occurs, or if the opposite flip-flop is first up, or the first up signal is not also the first down signal thus indicating that full rotation to the next detent valley was not accomplished.

Accordingly, the outputs of the phase detector and counter control circuit 39 appear on the leads 42 and 43 for transfer to the incremental detent up-down counter 10 of Figure 7B. The counter 10 is a conventional semiconductor microcircuit available commercially and having several terminals including terminals $Q_0$, $Q_1$, $Q_2$ and $Q_3$ and terminals:

UP is the count-up count-down terminal,

$\overline{CO}$ is a carry-out terminal,

$\overline{CI}$ is a carry-in terminal,

$P_0$, $P_1$, $P_2$, and $P_3$ are terminals set at pre-determined fixed voltage values, as indicated in the drawing,

$\overline{PE}$ is a preset-enable terminal, and

R is the grounded reset terminal.

A clock terminal is also provided. With respect to the terminal marked UP, it receives both count-up or high signals and count-down or low signals on the lead 42 by virtue of receiving binary input.

The signal transitions on the lead 43 represent the number of detents passed and are applied to the clocking terminal of the counter 10. The signal on the lead 42 is derived from one or the other side of the phase detector circuit 39 and is coupled to the UP terminal of the up-down counter 10. The $Q_0$, $Q_1$, $Q_2$ and $Q_3$ outputs of the counter 10 are applied through the plurality of leads 13 and the corresponding array of inverting amplifiers 6 to the conventional sub-system 5a for continuous summing of the incremental detent counts. The $Q_3$ output of the counter 10 is doubly inverted because of the presence of a second inverter 156. The inverters 6 serve two purposes; first, these inverters convert the outputs of the counter 10 from off-set binary to two's complement logic. Secondly, they serve as buffers. As to the inverters in the $Q_3$ output, that output needs at least one buffer and two inverters are used in series to preserve polarity. Accordingly, it is seen that the phase detector and control circuit 39 of Figure 7A drives the incremental two's complement up-down counter 10 which stores the number of detents passed in any one incremental operation of knob 20 and its corresponding direction of rotation. The counter 10 is interrogated and reset at regular intervals by computer sub-system 5a by signals passed by leads 11, 14 and NAND gate 162 to the preset-enable terminal PE of the counter 10. A second input terminal 63 of the NAND gate 162 accepts a signal that represents the presence of operating power.

For the protection of system operation against count overflow in the counter 10, the carry-out terminal $\overline{CO}$ thereof is fed by lead 41 to inverting amplifier 164 and thence to one input of NOR gate 160. The second input of NOR gate 160 is derived from the output of a cooperating NOR gate 161, this output being further supplied via lead 12 to the carry-in terminal $\overline{CI}$ of the counter 10. The overflow protection circuit is completed by coupling the output of the NAND gate 162 to a second input of the NOR gate 161.

Normally, the counter 10 will be interrogated and cleared before overflow can occur. The overflow protection circuit guarantees that in the exceptional case of fast rotation, a maximum count of the correct polarity will be transferred.

The clock 175, which alternates the flow of detent-passage-representing signals through the pulse synchroniser flip-flops 75 and 76, may also be the clock controlling the operation of computing sub-systems 5a, 5b, including whatever convenient code converting circuits 5b, and 3, ......,3n are necessary to convert the signal output format at the inverter array 6 into a signal format capable of operating a predetermined type of conventional numerical display, such as the digit displays 1, ......1n of Figure 7B.

Accordingly, the described repeater means provides a system which electro-optically converts a physical rotational input into electrical pulses for supply to a numerical display device for indicating the amount and direction of the rotation or for computer processing thereof. The repeater means eliminates difficulties of the prior art by providing an optical pulse-forming switch interfaced via a synchronised flip-flop system with a phase detection and counter control circuit which determines rotation extent and direction. The counter control drives a counter that stores the number of rotational increments passed and stores direction of rotation. The counter is interrogated and reset at regular intervals by a digital computer which converts the input knob angular rotation into a digital quantity by maintaining a running summation of counter values. The operator reference display is brought up to date with the newly converted value following each input conversion.

The described repeater means is easily made precise and eliminates the need for an analog-to-digital converter. Arcing and contact bounce phenomena are eliminated. Because of its simplicity, the pick-off may itself easily be made smaller than commercial optical encoders in sizes equivalent to those of the smaller synchro devices.

Claims

1.        Shaft angle repeater means characterised by including rotatable shaft means (21), means (22,23) permitting the rotatable shaft means (21) normally to assume any one of a plurality of equiangularly spaced locations, angle pick-off means (30) cooperating with the rotatable shaft means (21) for producing first and second pulse trains, each pulse thereof being substantially symmetric, when the rotatable shaft means (21) is rotated from a first to a second of said equiangularly spaced locations, the first and second pulse trains having the respective pulses thereof aligned in cooperating-overlapping relation whereby the pulses of the first pulse train are formed first for one sense of rotation of the rotatable shaft means (21) and the pulses of the second pulse train are formed first for the second sense of rotation of the rotatable shaft means (21), first circuit means responsive to the first formed pulses for generating a signal representative of the sense of rotation of the rotatable shaft means, second circuit means responsive to the first and second pulse trains for generating a signal representative of the number of the pulses, and utilisation means (1) responsive to the signal representative of the sense of rotation of the rotatable shaft means and to the signal representative of the number of the pulses.

2.        Shaft angle repeater means according to claim 1, characterised in that the means permitting the rotatable shaft means normally to assume any one of a plurality of equiangularly spaced locations comprises detent means (22,23).

3.        Shaft angle repeater means according to claim 1 or 2, characterised in that the utilisation means comprises display means (1) for continuously displaying a numerical measure of the angular position of the shaft means (21).

4.        Shaft angle repeater means according to any of the preceding claims, characterised in that the angle pick-off means (30) includes symmetric rotary shutter means (54) driven by the rotatable shaft means (21) for making a plurality of rotations when the shaft means (21) is rotated from a first to an immediately adjacent second of the equiangularly spaced locations.

5.      Shaft angle repeater means according to claim 4, characterised in that the rotary shutter means (54) includes symmetrically opposed indentations (75', 76') at the periphery thereof.

6.      Shaft angle repeater means according to claim 5, characterised in that the angle pick-off means (30) further includes first and second angularly disposed light source means (60) aligned with the periphery of the rotary shutter means (54), and optical detector means (52,53) responsive to the first or to the second light source means only when one of the opposed indentations (75', 76') is disposed between at least one of the first or second light source means and the optical detector means (52,53).

7.      Angle repeater means characterised by including angle pick-off means (30) having stator means (52,53,56, 57,60) and rotor means (54) for producing first and second pulse trains upon rotation of the rotor means (54) through an integral number of revolutions, the first and second pulse trains having the respective pulses thereof aligned in cooperating-overlapping relation whereby the pulses of the first pulse train are formed first for one sense of rotation of the rotor means (54) and the pulses of the second pulse train are formed first for the second sense of rotation of the rotor means (54), processor means (5,10,37,39) responsive to the first formed pulse train for generating a signal representative of the sense of rotation of the rotor means (54) and responsive to the first and second pulse trains for generating a signal representative of the number of pulses characterising the first and second pulse trains, and utilisation means (1) responsive to the signal representative of the sense of rotation of the rotor means (54) and to the signal representative of the number of pulses characterising the first and second pulse trains.

8.      Angle repeater means according to claim 7, characterised in that the utilisation means comprises
display means (1) for continuously indicating a numerical
measure of the algebraic sum of the number of integral
revolutions of the rotor means (54).

9.        Angle repeater means adapted for use with angular
position pick-off means producing first or second pulse
trains upon rotation thereof through an integral number of
complete revolutions in a first or in a second direction,
the repeater means being characterised by including clock
means (5), first and second bistable means (75,76)
responsive to the clock means (5) and cooperatively forming
pulse synchroniser means (37) and respectively responsive
to the first and second pulse trains, each of the bistable
means having respective Q and $\overline{Q}$ outputs, phase detector
means (39) responsive to the respective Q and $\overline{Q}$ outputs
for generating a first control signal representative of the
sense of the first or second directions and a second control
signal representative of the number of pulses in the first
or second pulse trains, counter means (10) responsive to
the first and second control signals, and display means (1)
responsive to the clock means (5) and to the counter means
(10) for displaying a true numerical measure of the total
angular motion of the angular position pick-off means (30).

10.       Angle repeater means according to claim 9,
characterised in that the phase detector means (39) includes
third bistable means (84) having a data input responsive
to the $\overline{Q}$ output of the first bistable means (75) and a
clocking input responsive to the $\overline{Q}$ output of the second
bistable means (76), and fourth bistable means (87) having
a data input responsive to the $\overline{Q}$ output of the second
bistable means (76) and a clocking input responsive to the
$\overline{Q}$ output of the first bistable means (75).

11.       Angle repeater means according to claim 10,
characterised in that the phase detector means (39) further
includes first AND gate means responsive to the respective
Q outputs of the third and fourth bistable means for
cooperatively forming the second control signal for the counter
means (10).

12.      Angle repeater means according to claim 11, characterised in that the phase detector means (39) further includes fifth bistable means having a data input responsive to the Q output of the first bistable means and a clocking input responsive to the Q output of the first bistable means, and sixth bistable means having a data input responsive to the Q output of the second bistable means and a clocking input responsive to the Q output of the first bistable means.

13.      Angle repeater means according to claim 12, characterised in that the phase detector means further includes OR gate means responsive to the respective Q outputs of the third and fourth bistable means for controlling the CLEAR terminals of the fifth and sixth bistable means.

14.      Angle repeater means according to claim 13, characterised in that the first AND gate means is additionally responsive to the Q outputs of the fifth and sixth bistable means.

15.      Angle repeater means according to claim 14, characterised in that the Q output of the third bistable means is coupled as the first control signal to the counter means up-down input terminal.

16.      Angle repeater means according to claim 15, characterised in that said phase detector means (39) further includes second AND gate means responsive to the Q output of said third bistable means and to the Q output of said sixth bistable means, and third AND gate means responsive to the Q̄ output of said fourth bistable means and to the outputs of said first and second AND gate means for control of the CLEAR input of said third bistable means.

17.      Angle repeater means according to claim 16, characterised in that said phase detector means (39) further includes fourth AND gate means responsive to the Q output of said fifth bistable means and to the Q output of said fourth bistable means, and fifth AND gate means responsive to the Q̄ output of said third bistable means and to the outputs of said first and fourth AND gate means for control of the CLEAR input of said fourth bistable means.

18.        Angle repeater means according to any of claims 9 to 17, characterised by further including count overflow protective circuit means (9) coupled in cooperative relation with said counter means (10).

FIG.1

FIG.2

FIG.3

FIG.4

FIG.5

FIG.6

FIG.7A

PHASE DETECTOR AND COUNTER CONTROL 39

PULSE SYNCHRONIZER 37

OPTICAL PULSING SWITCH 30

0037192

FIG.7B

0037192

0037192

**European Patent Office**

**EUROPEAN SEARCH REPORT**

Application number

EP 81 30 1011

## DOCUMENTS CONSIDERED TO BE RELEVANT

| Category | Citation of document with indication, where appropriate, of relevant passages | Relevant to claim |
|---|---|---|
| X | DE - A - 2 752 238 (MARABUWERKE)<br><br>* page 1; page 2, claim 3; page 4 - page 8, line 21; page 12 - page 13; figure *<br><br>-- | 1-3 |
| X | DE - A - 2 822 672 (LOEWE OPTA)<br><br>* page 2, claim 1; page 2, claims 2,4,5,6; figures 1,2 *<br><br>-- | 1-3 |
| | US - A - 3 299 410 (GRABOW)<br><br>* column 4, lines 19-49 *<br><br>-- | 4,6 |
| X | DE - A - 2 824 295 (PIONEER)<br><br>* page 5, lines 8-24; page 10, line 14 - page 11, line 18; figures 1,2 *<br><br>-- | 7,8 |
| A | US - A - 3 670 324 (TREVOR)<br><br>---------------- | 9-17 |

### CLASSIFICATION OF THE APPLICATION (Int. Cl.³)

G 08 C 9/08
G 01 D 5/245
H 03 K 13/18

### TECHNICAL FIELDS SEARCHED (Int. Cl.³)

G 01 D 5/245
5/36
G 08 C 19/18
H 03 K 13/18
G 01 P 3/48
G 01 B 3/12
H 03 J 5/02

### CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| THE HAGUE | 19-06-1981 | GUIVOL |

EPO Form 1503.1   06.78